(19) **Europäisches Patentamt**
**European Patent Office**
**Office européen des brevets**

(11) **EP 2 022 625 B1**

(12) **EUROPEAN PATENT SPECIFICATION**

(45) Date of publication and mention
of the grant of the patent:
**24.07.2013 Bulletin 2013/30**

(51) Int Cl.:
**B32B 9/04** (2006.01)   **B32B 15/08** (2006.01)
**C23C 14/28** (2006.01)

(21) Application number: **07743533.7**

(22) Date of filing: **17.05.2007**

(86) International application number:
**PCT/JP2007/060098**

(87) International publication number:
**WO 2007/138865 (06.12.2007 Gazette 2007/49)**

(54) **LAMINATED BODY FOR RESIN GLASS AND METHOD FOR MANUFACTURING SUCH LAMINATED BODY**

**LAMINIERTER KÖRPER FÜR HARZGLAS UND VERFAHREN ZUR HERSTELLUNG SOLCH EINES LAMINIERTEN KÖRPERS**

**CORPS STRATIFIÉ POUR VERRE DE RÉSINE ET SON PROCÉDÉ DE FABRICATION**

(84) Designated Contracting States:
**DE FR GB IT**

(30) Priority: **26.05.2006   JP 2006147343**

(43) Date of publication of application:
**11.02.2009   Bulletin 2009/07**

(73) Proprietors:
• **KABUSHIKI KAISHA TOYOTA JIDOSHOKKI**
**Kariya-shi, Aichi 448-8671 (JP)**
• **TOYOTA JIDOSHA KABUSHIKI KAISHA**
**Toyota-shi,**
**Aichi-ken, 471-8571 (JP)**

(72) Inventors:
• **SHIMO, Toshihisa**
**Kariya-shi**
**Aichi 448-8671 (JP)**
• **MURAMATSU, Hisashi**
**Kariya-shi**
**Aichi 448-8671 (JP)**
• **HIRAMATSU, Hiroyasu**
**Kariya-shi**
**Aichi 448-8671 (JP)**
• **KONDO, Toshiro**
**Kariya-shi**
**Aichi 448-8671 (JP)**

• **KATO, Makoto**
**Aichi-gun**
**Aichi 480-1192 (JP)**
• **FUKUMORI, Kenzo**
**Aichi-gun**
**Aichi 480-1192 (JP)**
• **KATAGIRI, Yosihide**
**Aichi-gun**
**Aichi 480-1192 (JP)**
• **NAGAI, Takayuki**
**Toyota-shi**
**Aichi 471-8571 (JP)**
• **WATANABE, Toshio**
**Toyota-shi**
**Aichi 471-8571 (JP)**

(74) Representative: **TBK**
**Bavariaring 4-6**
**80336 München (DE)**

(56) References cited:
**EP-A1- 1 070 762      EP-A2- 0 726 579**
**WO-A1-01/47704      WO-A1-02/02320**
**JP-A- 08 309 913      JP-A- 10 052 876**
**JP-A- 2004 035 614      JP-A- 2005 126 609**
**JP-A- 2005 126 785      JP-A- 2005 126 788**
**JP-A- 2005 126 789      JP-A- 2006 082 319**
**US-A- 6 090 490      US-A1- 2004 018 364**

**Description**

**Technical Field**

The present invention relates to a laminated body for resin glass and a method for manufacturing the same.

**Background of the Invention**

Generally, a polymer substrate for resin glass such as a polycarbonate resin has low adhesion to a hard coating due to low surface free energy thereof. As a result, sufficient adhesion generally can not be obtained without some sort of surface treatment (pre-coating treatment) being performed. Consequently, various primer coatings have been applied conventionally as a method of this pre-coating treatment ("Polycarbonate Resin Handbook", edited by Seiichi Honma, Nikkan Kogyo Shimbun Ltd., published at Aug. 28, 1992).

However, there is a problem that this kind of primer coating causes a large environmental load because the primer is often diluted with an organic solvent. In addition, this kind of primer coating requires substantial time because the primer needs to be applied multiple times. Moreover, this kind of primer coating also has a problem in economical efficiency because the primer needs to contain a large amount of an ultraviolet absorber in order to prevent ultraviolet degradation of a polymer substrate for resin glass.

JP 2005126789 (A) describes a plating method, wherein scattering particles of metal are deposited on the surface of a base material composed of a material containing carbon atoms to deposit a metallic film on the base material while irradiating the surface with vacuum UV rays of 50-100 nm wavelength, and another metallic film is deposited on the metallic film formed on the surface of the base material by an electroless/electric plating method.

JP 2005126788 (A) describes a method for hardening the surface of a resin molding, a target formed of at least one material selected from the group consisting of metal, metal compound and carbon is irradiated with pulse laser beams of a pulse width of 100 ps to 100 ns and a certain irradiation intensity of, and vacuum UV rays of a wavelength of 50 to 100 nm and scattering particles containing metal atoms and/or carbon atoms are generated.

JP 2005126785 (A) describes a joining method comprising a joining pretreatment step of depositing scattering particles containing carbon atoms on a surface of a base member formed of metallic materials while irradiating vacuum UV ray of the wavelength of 50-100 nm, and a joining step of joining other member on the surface of the base member with the scattering particles deposited thereon.

JP 2005126609 (A) describes an adhesion method comprising an adhesion pretreatment process wherein a scattering particle containing a metal atom and/or carbon atom is adhered on the surface of a substrate made of a carbon atom-containing material which is irradiated by vacuum UV ray of 50-100 nm wavelength; and an adhesion process wherein an adhesive agent is coated on the surface of the substrate adhered by the scattering particle to form an adhesive layer, with which the substrate is then adhered to the other material.

EP 1070762 (A1) concerns a metal alloy based on aluminium and titanium whereof the aluminium content ranges between 80 and 90 atoms per hundred and the titanium content ranges between 10 and 20 atoms per hundred. It also concerns a reflecting coating of said metal alloy, preferably of thickness ranging between 0.01 and 3 $\mu$m, covered with a protective film, e.g. in polymer material.

EP 0726579 (A2) relates to a transparent conductive sheet comprising a silicon oxide gas barrier layer, an organosilicon compound-containing solvent-resistant layer and a transparent conductive layer laminated in that order on one side of a transparent plastic substrate, or a polyvinyl alcohol-based resin gas barrier layer and a solvent-resistant layer laminated in that order, over an anchor coat layer.

WO 0202320 (A1) describes coatings, particularly thin films, of polymeric material are produced by applying a finely divided aerosol of polymer solution to a substrate and substantially simultaneously applying an energy source to the applied solution to apply the solution. Another aspect is the co-deposition process used to provide thin polysiloxane coatings on glass and other substrates.

WO 0147704 (A1) describes a modified chemical vapor deposition (CVD) method and various coatings formed by this method. A uniform coating is obtained by the CVD method by redirecting the energy source and/or the hot gasses produced thereby. The methods are particularly useful for forming thin film, insulative, oxide coatings on the surface of conductive or superconductive wires.

US 2004018364 (A1) relates to a gas barrier film comprising a composite film provided with a gas barrier layer having a laminated structure including at least a metal oxide thin layer on a substrate film having a (1) 80 ppm/°C or less coefficient of thermal expansion at 50°C to 150°C and/or a 10 ppm/% RH or less coefficient of humidity expansion at 25°C, and a (2) 150°C or more glass transition temperature, and a display with a display element covered with the same.

US 6090490 (A) describes an article being coated with a multi-layer coating comprising a polymeric layer deposited on the surface of the article, a zirconium compound, titanium compound or zirconium/titanium alloy compound layer deposited on the polymeric layer, and a silicone resin layer deposited on the zirconium compound or titanium compound layer.

## Disclosure of the Invention

The present invention has been made in consideration of the above-described problems in the conventional techniques. An object of the present invention is to provide a laminated body for resin glass, and a method for manufacturing the laminated body for resin glass capable of efficiently and reliably manufacturing the laminated body for resin glass. The laminated body for resin glass has sufficiently high adhesion between a polymer substrate for resin glass and a hard coating layer without a conventional primer coating being performed, and can exhibit excellent abrasion-resistance as well as high weatherability by which the polymer substrate for resin glass is sufficiently prevented from degradation caused by ultraviolet irradiation.

The present inventors have earnestly studied in order to achieve the above object. As a result, the inventors have revealed that a laminated body for resin glass which has sufficiently high adhesion between a polymer substrate for resin glass and a hard coating layer without a conventional primer coating being performed, and which can exhibit excellent abrasion-resistance as well as high weatherability by which the polymer substrate for resin glass is sufficiently prevented from degradation caused by ultraviolet irradiation, can surprisingly be obtained by causing fine particles of, for example, a specific metal to adhere onto the polymer substrate for resin glass and laminating a hard coating layer containing a specific organic compound to the polymer substrate having interposed therebetween an inorganic layer formed by the adhesion of the particles. This discovery has led the inventors to complete the present invention.

To be more specific, the laminated body for resin glass of the present invention as defined by claim 1 comprises a polymer substrate for resin glass, an inorganic layer formed by causing fine particles having an average diameter of from 0.1 to 500 nm of at least one substance selected from the group consisting of silicon, titanium, a silicon compound and a titanium compound to adhere onto the polymer substrate for resin glass and an alkoxysilane-containing hard coating layer laminated to the polymer substrate for resin glass having the inorganic layer interposed therebetween.

The above-mentioned inorganic layer according to the present invention is a layer formed: by irradiating laser light to a surface of a base material to generate vacuum-ultraviolet light having a wavelength of 50 nm to 100 nm and flying particles; and by causing the flying particles to adhere onto the polymer substrate for resin glass with irradiation of the vacuum-ultraviolet light, said base material being made of a material comprising at least one substance selected from the group consisting of silicon, titanium a silicon compound and a titanium compound.

In addition, a method for manufacturing a laminated body for resin glass of the present invention according to claim 4 comprises the steps of, forming an inorganic layer by causing fine particles of at least one substance selected from the group consisting of silicon, titanium, a silicon compound and a titanium compound to adhere onto a polymer substrate for resin glass, and laminating an alkoxysilane-containing hard coating layer to the polymer substrate for resin glass having the inorganic layer interposed therebetween.

In the above-mentioned method for manufacturing the laminated body for resin glass of the present invention, the step of forming the inorganic layer is a step of forming an inorganic layer: by irradiating laser light to a surface of a base material to generate vacuum-ultraviolet light having a wavelength of 50 nm to 100 nm and flying particles; and by causing the flying particles to adhere onto the polymer substrate for resin glass with irradiation of the vacuum-ultraviolet light, said base material being made of a material comprising at least one substance selected from the group consisting of silicon, titanium, a silicon compound and a titanium compound.

Moreover, in the above-mentioned method for manufacturing the laminated body for resin glass of the present invention, the laser light is preferably a pulsed laser light having a pulse width of 100 picoseconds to 100 nanoseconds and an irradiation intensity of $10^6$ W/cm$^2$ to $10^{12}$ W/cm$^2$.

Furthermore, in the above-mentioned method for manufacturing the laminated body for resin glass of the present invention, it is preferable that the flying particles are caused to adhere onto the surface of the polymer substrate for resin glass under a reduced pressure condition and/or a shielding gas atmosphere comprising at least one gas selected from the group consisting of hydrogen gas, helium gas, neon gas and argon gas.

The above-mentioned polymer substrate for resin glass according to the present invention preferably comprises at least one resin selected from the group consisting of a polycarbonate resin, a polymethyl methacrylate resin, a methyl methacrylate resin, a transparent acrylonitrile butadiene styrene resin, a transparent polystyrene resin, a transparent epoxy resin, a polyarylate, a polysulfone, a polyethersulfone, a transparent nylon resin, a transparent polybutylene terephthalate, a transparent fluororesin, poly-4-methylpentene-1, a transparent phenoxy resin, a polyimide resin and a transparent phenol resin, and more preferably comprises a substrate consisting of a polycarbonate resin.

Here, it is not known exactly why the laminated body for resin glass and the method for manufacturing the same of the present invention can achieve the above object. However, the inventors of the present invention speculate as follows. First, in the present invention, the surface of polymer substrate for resin glass is maintained in an active state because fine particles of at least one substance selected from the group consisting of silicon, titanium, a silicon compound and a titanium compound, which have high surface energy, adhere onto the surface of the polymer substrate for resin glass, which has low surface free energy. Therefore, adhesion between a hard coating layer and the polymer substrate for resin glass is increased. Moreover, in the present invention, the hard coating layer contains an alkoxysilane. Such an alkoxysilane has high reactivity to fine particles of at least one substance selected from the group consisting of silicon, titanium, a silicon compound and a titanium compound and readily react with the particles. For this reason, the hard coating layer of the present invention can exhibit higher adhesion than hard coating layers which uses other materials. Furthermore, surprisingly, it has been found that the specific inorganic layer according to the present invention exhibits high weatherability. The inventors of the present invention speculate that this is because the inorganic layer has high reflectance to the ultra-violet light having a wavelength region which deteriorates the polymer substrate for resin glass.

The present invention makes it possible to provide a laminated body for resin glass, and a method for manufacturing the laminated body for resin glass capable of efficiently and reliably manufacturing the laminated body for resin glass. The laminated body for resin glass has sufficiently high adhesion between a polymer substrate for resin glass and a hard coating layer without a conventional primer coating being performed, and can exhibit excellent abrasion-resistance as well as high weatherability by which the polymer substrate for resin glass is sufficiently prevented from degradation caused by ultraviolet irradiation.

**Brief Description of the Drawings**

[FIG. 1] FIG. 1 is a schematic diagram of a basic configuration of a preferred embodiment of equipment to form an inorganic layer.
[FIG. 2] FIG. 2 is a schematic diagram showing positional relationship of a target and a polymer substrate for resin glass arranged in a treatment container.

**Detailed Description of the Preferred Embodiments**

The present invention will be described below in detail according to preferred embodiments.

A laminated body for resin glass of the present invention will be described. To be more specific, the laminated body for resin glass of the present invention includes: a polymer substrate for resin glass; an inorganic layer formed by causing fine particles of at least one substance selected from the group consisting of silicon, titanium, a silicon compound and a titanium compound to adhere onto the polymer substrate for resin glass; and an alkoxysilane-containing hard coating layer laminated to the polymer substrate for resin glass having the inorganic layer interposed therebetween.

The polymer substrate for resin glass according to the present invention may be a substrate formed with a polymer resin that can be used for resin glass and is not particularly limited. As the polymer substrate, preferable is a substrate including at least one resin selected from the group consisting of a polycarbonate resin, a polymethyl methacrylate resin, a methyl methacrylate resin, a transparent acrylonitrile butadiene styrene resin, a transparent polystyrene resin, a transparent epoxy resin, a polyarylate, a polysulfone, a polyethersulfone, a transparent nylon resin, a transparent polybutylene terephthalate, a transparent fluororesin, poly-4-methylpentene-1, a transparent phenoxy resin, a polyimide resin and a transparent phenol resin. Of these polymer substrates for resin glass, a polymer substrate for resin glass formed of a polycarbonate resin is specifically preferable from the viewpoint of having higher transparency and exhibiting excellent toughness.

The thickness of the polymer substrate for resin glass is not particularly limited because the thickness varies as appropriate depending on the design of the obtained laminated body for resin glass. The thickness of the polymer substrate is 1 to 10 mm, for example, in automotive and other use. If the polymer substrate is thinner than the lower limit, the laminated body for resin glass tends to be less practical because the laminated body for resin glass has a low rigidity and warps. On the other hand, if the thickness is higher than the upper limit, the laminated body for resin glass tends to be less practical because the laminated body for resin glass becomes heavy. In addition, the shape of such a polymer substrate for resin glass is not particularly limited, and various shapes can be selected as appropriate depending on an application of an obtained laminated body for resin glass.

An inorganic layer according to the present invention is formed by causing fine particles of at least one substance selected from the group consisting of silicon, titanium, a silicon compound and a titanium compound to adhere onto the polymer substrate for resin glass.

Such a silicon compound and a titanium compound are not particularly limited, and include: oxides, nitrides, carbides and sulfides of any of silicon and titanium; and complex compounds of silicon and titanium. Such a silicon compound and a titanium compound specifically includes silica, glass, silica glass, talc, wollastonite, potassium titanate, titanium oxide, silicon carbide and silicon nitride. Moreover, among these silicon compounds and titanium compounds, from the viewpoint of higher reactivity to an alkoxysilane contained in a hard coating layer to provide higher adhesion to the hard coating layer, silica, glass, silica glass, talc, wollastonite, potassium titanate, titanium oxide are preferable, and silica, glass, silica glass, titanium oxide are more preferable.

For such an inorganic layer, the layer is formed by irradiating laser light to a surface of a base material containing at least one substance selected from the group consisting of silicon, titanium, a silicon compound and a titanium compound to generate vacuum-ultraviolet light having a wavelength of 50 nm to 100 nm and flying particles and by causing the flying particles to adhere onto the polymer substrate for resin glass with irradiation of the vacuum-ultraviolet light. Such an inorganic layer tends to increase adhesion between the polymer substrate for resin glass and the hard coating layer.

The term vacuum-ultraviolet light having a wavelength of 50 nm to 100 nm here means vacuum-ultraviolet light having at least a part of wavelength region from 50 nm to 100 nm, and it is preferable that the vacuum-ultraviolet light satisfies at least one condition selected from the following conditions.

(i) The vacuum-ultraviolet light has at least one peak of light intensity in the wavelength region from 50 nm to 100 nm;
(ii) The total energy of light in the region from 50 nm to 100 nm is higher than the total energy of light in the region from 100 nm to 150 nm;
(iii) The total energy of light in the region from 50 nm to 100 nm is higher than the total energy of light in the region of 50 nm or less;
(iv) The energy density of light in the region from 50 nm to 100 nm is 0.1 $\mu J/cm^2$ to 10 $mJ/cm^2$ (more preferably 1 $\mu J/cm^2$ to 100 $\mu J/cm^2$) on the polymer substrate for resin glass. Note that, if the energy density on the substrate is lower than 0.1 $\mu J/cm^2$, required time for treatment tends to be excessively long. In contrast, if the energy density is higher than 10 $mJ/cm^2$, the substrate tends to be decomposed.

Moreover, consider a case where this method of causing the flying particles to adhere by laser light irradiation is employed. When the flying particles are caused to adhere onto a surface of the polymer substrate for resin glass under a shielding gas atmosphere, for example, use of a container whose inner pressure is reduced results in vacuum-ultraviolet light irradiation to the surface of the polymer substrate for resin glass without absorption of the light by vacuum-ultraviolet light absorbing substances such as oxygen in air. As a result, the surface of the polymer substrate for resin glass tends to be activated more efficiently. In addition, when it is treated under a shielding gas atmosphere, vacuum-ultraviolet light can be irradiated to the surface of the polymer substrate for resin glass without absorption of the light by vacuum-ultraviolet light absorbing substrates even not in reduced pressure. As a result, the surface of the substrate tends to be activated more efficiently. Moreover, in the latter case, use of a vacuum pump or a pressure-resistant container is not required in contrast to the former case, so that the latter case is more preferable in terms of simplicity of equipment and lower cost.

The thickness of the inorganic layer is preferably 0.5 to 1,000 nm, and more preferably 1 to 100 nm. If the thickness of the inorganic layer is lower than the lower limit, the surface free energy tends not to become sufficiently high because the amount of particles forming the inorganic layer is small. On the other hand, if thickness of the inorganic layer is higher than the upper limit, the inorganic layer tends to peel off spontaneously by a stress generated from residual strain. The inorganic layer is not necessarily in the form of film, and may be formed by causing the fine particles to adhere dispersedly.

The average particle diameter of the fine particles is 0.1 to 500 nm. If the average particle diameter is smaller than the lower limit, treatment under a shielding gas atmosphere tends to be difficult. On the other hand, when the average particle diameter is larger than the upper limit, treatment tends to become nonuniform.

The hard coating layer of the present invention is an alkoxysilane-containing hard coating layer laminated onto the polymer substrate for resin glass having the inorganic layer interposed therebetween. As described above, the hard coating layer of the present invention contains an alkoxysilane. Moreover, the alkoxysilane has high reactivity to at least one substance selected from the group consisting of silicon, titanium, a silicon compound and a titanium compound which form the inorganic layer. Therefore, molecules of the alkoxysilane and the surface of the polymer substrate for resin glass are bonded strongly, so that high adhesion of the hard coating layer can be achieved.

The material forming the hard coating layer contains an alkoxysilane. Commercially available hard coating materials include, for example, Tossguard 510 (manufactured by GE Toshiba Silicone Co., Ltd.), Solguard NP-720 and Solguard NP-730 (manufactured by Nippon Dacro shamrock Co., Ltd.) and KP-851 and KP-854 (manufactured by Shin-Etsu Chemical Co., Ltd.).

For these hard coating materials, a compound containing an organopolysiloxane composition including a condensation compound of a hydrolyzed organosilane represented by the general formula (1) as an alkoxysilane:

$$(R^1)_n Si(OR^2)_{4-n} \qquad (1)$$

(where each $R^1$ maybe the same or different and represents a monovalent organic group containing 1 to 10 carbon atoms; n represents an integer of 0 to 2; and each $R^2$ may be the same or different and represents a hydrogen atom or monovalent organic group) is used.

The thickness of such a hard coating layer after heat curing is 0.2 to 20. $\mu$m, and preferably 0.5 to 10 $\mu$m. If the thickness of such a hard coating layer is lower than the lower limit, the desired hardness and abrasion resistance tend not to be obtained. On the other hand, if the thickness of this hard coating layer is higher than the upper limit, cracks tend to be generated by stress generated during heat curing and adhesion tends to decrease.

The laminated body for resin glass of the present invention has been described above, and a method for manufacturing a laminated body for resin glass of the present invention which is preferable for producing the above-mentioned laminated body for resin glass of the present invention will be described below.

A method for manufacturing a laminated body for resin glass of the present invention includes the steps of forming an inorganic layer by causing fine particles of at least one substance selected from the group consisting of silicon, titanium, a silicon compound and a titanium compound to adhere onto a polymer substrate for resin glass (an inorganic layer forming process), and laminating an alkoxysilane-containing hard coating layer to the polymer substrate for resin glass having the inorganic layer interposed therebetween (a hard coating layer laminating process).

(Inorganic layer forming process)

Such a process of forming the inorganic layer is a process of forming the inorganic layer by employing a laser ablation method. The process of forming the inorganic layer by employing a laser ablation method is preferable from the viewpoint of enabling higher adhesion of the hard coating layer to be achieved. In addition, of processes for forming the inorganic layer by employing laser ablation methods, a process of forming the inorganic layer by irradiating laser light to a surface of a base material comprising at least one substance selected from the group consisting of silicon, titanium, a silicon compound and a titanium compound to generate vacuum-ultraviolet light having a wavelength of 50 nm to 100 nm and flying particles and forming the inorganic layer by causing the flying particles to adhere onto the polymer substrate for resin glass with irradiation of the vacuum-ultraviolet light is used.

A preferred embodiment of the process of forming the inorganic layer by employing a laser ablation method as a preferable inorganic layer forming process will be described below in detail referring to drawings. In the description and drawings below, symbols are given to the same or a corresponding elements and overlapping descriptions will be omitted.

First, preferable equipment for performing a process of forming an inorganic layer by employing laser ablation method will be described.

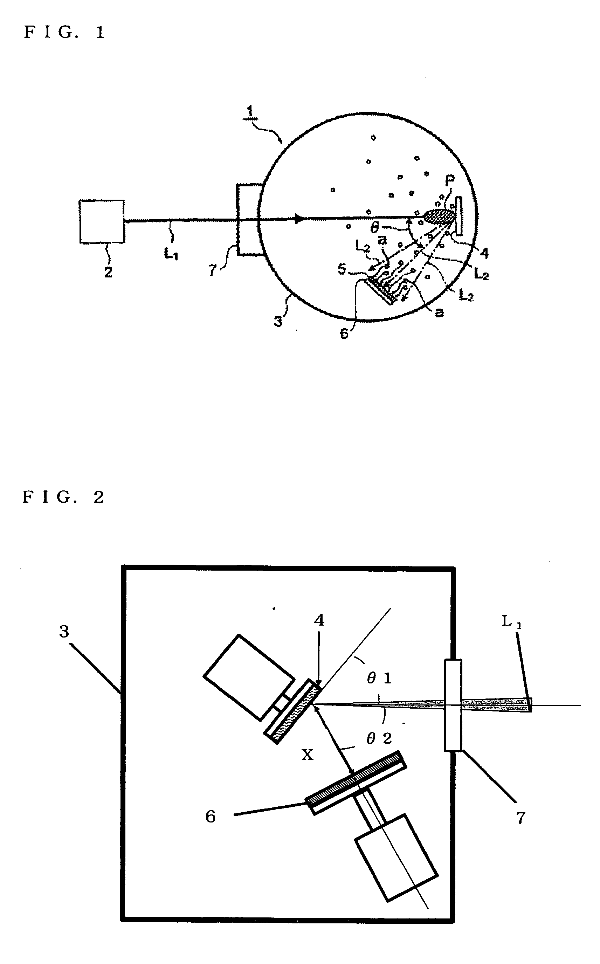

FIG. 1 is a schematic diagram of a basic configuration of a preferred embodiment of equipment for performing a process of forming the inorganic layer. The equipment shown in FIG. 1 is composed of so-called laser ablation equipment 1. To be more specific, the laser ablation equipment 1 shown in FIG. 1 includes a laser source 2 and a treatment container 3 into which laser light $L_1$ generated from the laser source 2 is introduced, and inside the treatment container 3, a target 4 to which the laser light $L_1$ is irradiated and a substrate 6 on whose surface an activated inorganic layer 5 will be formed are placed.

The laser source 2 may be a laser light generator which can irradiate pulsed laser light having a pulse width of 100 picoseconds to 100 nanoseconds, and is not particularly limited. For example, the laser source 2 is composed of a YAG laser equipment or an excimer laser equipment, and the YAG laser equipment is particularly preferable. The laser source 2 is placed at the position of irradiating laser light $L_1$ to the target 4 which is located inside the treatment container 3. In addition, although not illustrated, lenses and mirrors can be placed as appropriate at a midpoint in a light path of the laser light $L_1$ to adjust energy density and the irradiation angle of the laser light for the purpose of effective generation of vacuum-ultraviolet light $L_2$ and flying particles a containing silicon, titanium and a compound thereof from the surface of the target 4 when the laser light $L_1$ is irradiated to the target 4. Particularly, by placing a condenser lens (not illustrated) inside or outside the treatment container 3, the irradiation intensity of the pulsed laser light $L_1$ irradiated to the target 4 is preferably adjusted from $10^6$ W/cm$^2$ to $10^{12}$ W/cm$^2$, and particularly preferably $10^8$ W/cm$^2$ to $10^{11}$ W/cm$^2$.

The treatment container 3 (for example, a container made of stainless steel) accomodates at least the target 4 and the substrate 6 and includes a window 7 (for example a window made of silica glass) for introducing the laser light $L_1$ to the surface of the target 4 placed in the container 3. In addition, a vacuum pump (not illustrated) is connected to the treatment container 3, so that inner pressure of the container 3 can be maintained at a certain level in a reduced pressure state. When the container 3 whose inside is in the reduced pressure state as described above is used, the vacuum-ultraviolet light $L_2$ is irradiated to the surface of the substrate 6 without being absorbed by a vacuum-ultraviolet light absorbing substance such as oxygen in the air, and the surface of the substrate 6 is more efficiently activated. The pressure when the inside of the container 3 is maintained in the reduced pressure state is preferably 1 Torr or lower, and more preferably $1 \times 10^{-3}$ Torr or lower. In addition, the partial pressure of oxygen and/or the partial pressure of nitrogen are preferably 1 Torr or lower.

The target 4 may be a material generating flying particles containing silicon, titanium, a silicon compound and a titanium compound by irradiation of the laser light $L_1$. Moreover, the target 4 may be a composite material made of silicon, titanium, a silicon compound and a titanium compound. Shape of the target 4 is not particularly limited, and a bulk material made of the target material formed in a shape of plate, rod and a tape-shaped target formed by applying or vapor-depositing the target material onto a tape can be used. As such silicon, titanium, a silicon compound and a titanium compound, the same substances described for the above-mentioned laminated body for resin glass according to the present invention can be used.

The substrate 6 is a polymer substrate for resin glass onto the surface of which fine particles should adhere, and is specifically determined as appropriate by an application of an obtained laminated body for resin glass. As these polymer substrates for resin glass, the same polymers described for the above-mentioned laminated body for resin glass of the present invention can be used.

The positional relation of the above-mentioned substrate 6 and the target 4 is not particularly limited. The substrate 6 is placed as appropriate with respect to the target 4 so that the vacuum-ultraviolet light $L_2$ generated from the surface of the target 4 can be surely irradiated to the surface of the substrate 6 and that the flying particles a can efficiently adhere onto the surface of the substrate 6. In FIG. 1, the substrate 6 is placed at such a position that the angle $\theta$ to a normal line of the target 4 is 45 degrees. In addition, a target driving equipment (for example, a target turntable; not illustrated) is connected to the target 4, so that a fresh part of the surface (a surface to which laser light has not irradiated yet) of the target can be sequentially placed at an irradiation position of the laser light $L_1$. Moreover, a substrate driving equipment (for example, a substrate turntable; not illustrated) may be connected to the substrate 6, so that the surface of the substrate 6 can be activated more uniformly.

An embodiment of preferable equipment to perform a process of forming the inorganic layer according to the present invention has been described above. However, preferable equipment to perform these processes is not limited to the equipment described in the above-mentioned embodiment. For example, in the above-mentioned embodiment, the treatment container 3 is connected to a vacuum pump (not illustrated). However, the treatment container 3 may also be connected to a gas cylinder (not illustrated) for introducing at least one shielding gas selected from the group consisting of hydrogen gas, helium gas, neon gas and argon gas. In this case, the inside of the container 3 can be maintained under a given shielding gas atmosphere. When the container 3 whose inside is under shielding gas atmosphere as described above is used, the vacuum-ultraviolet light $L_2$ can be irradiated to the surface of the substrate 6 without being absorbed by a vacuum-ultraviolet light absorbing substance and the surface of the substrate 6 is more efficiently activated even when inner pressure of the container 3 is not in a reduced pressure state. In addition, it is preferable that both a vacuum pump (not illustrated) and a gas cylinder (not illustrated) are connected to the container 3 and thus the interior of the container 3 is under shielding gas atmosphere as well as maintained under a given pressure condition. For such conditions, for example, a pressure less than or equal to atmospheric pressure under helium gas atmosphere is preferable, and a pressure not more that 500 Torr is more preferable. In addition, the partial pressure of oxygen and/or the partial pressure of nitrogen are preferably 1 Torr or lower.

In the above-mentioned embodiment, the laser source 2 is placed outside the treatment container 3. However, the laser source 2 may be placed inside of the treatment container 3 and, in that case, the window 7 for introducing the laser light $L_1$ into the container 3 will not be needed.

Moreover, in the above-mentioned embodiment, the substrate 6 is placed at a position that the angle $\theta$ to the normal line of the target 4 is 45 degrees. However, such a positional relation is not particularly limited, and the substrate 6 may be placed at a position that the angle $\theta$ to the normal line of the target 4 is in the range of about 10 to 60 degrees. In addition, for example, a substrate which can be transparent to the laser light $L_1$ is used as the substrate 6 made of a carbon containing material and the laser light $L_1$ passed through the substrate 6 may be irradiated to the target 4 by placing the substrate 6 at opposed position to the target 4 and between the laser source 2 and the target 4.

In addition, a material which can be transparent to the laser light $L_1$ may be used as the target 4, and the target 4 may be placed between the laser source 2 and the substrate 6. Then, the vacuum-ultraviolet light $L_2$ and flying particles a are generated from the surface of the target 4 (a target material side) by the laser light $L_1$ transmitted from the back surface (a transparent film side) to the front surface (a target material side) of the target 4 and vacuum-ultraviolet light $L_2$ and flying particles a may be supplied to the surface of the substrate 6. When such a configuration is used, formation of an inorganic layer on a relatively large substrate tends to be easier. A target used for such configuration is preferably a tape-shaped target formed by laminating the above-mentioned materials for a target by vapor deposition, pasting on a film which is transparent to the laser light (for example, PET film).

Then, a preferred embodiment for a process of forming an inorganic layer according to the present invention will be described with reference to FIG. 1.

Such a process of forming an inorganic layer, first, pulses laser light $L_1$ having a pulse width of 100 picoseconds to 100 nanoseconds from the laser source 2 to the above mentioned target 4. Then, a high temperature plasma P is formed on the surface of the target 4, and the plasma P generates vacuum-ultraviolet light $L_2$ having a wavelength of 50 nm to 100 nm. At the same time, molecules containing metal atoms and carbon atoms which depend on the material composing the target fly in all directions with high energy from the surface of the target 4 irradiated by the laser light $L_1$. In addition, neutral atoms, and ions which are formed by decomposition of molecules composing the target, and clusters formed by bonding of some of the molecules, the neutral atoms and the ions fly in all directions with high energy from the inside of the plasma P or the surface of the target 4 heated by the plasma P. Note that, if the pulse width of pulsed laser light $L_1$ is lower than 100 picoseconds, light having a wavelength shorter than 50 nm is generated because the energy of the laser is intensively irradiated to the target in a short period. On the other hand, if the pulse width of pulsed laser light $L_1$ is higher than 100 nanoseconds, the wavelength of the generated light exceeds 100 nm because the energy of the laser is not intensively irradiated in terms of time. In addition, if the wavelength of the generated light $L_2$ is lower than 50 nm or higher than 100 nm, in both cases, the absorption ratio of the light $L_2$ to a carbon atom containing material becomes lower and activation of the surface of the substrate becomes insufficient, so that adhesion strength between the hard coat layer and the substrate becomes insufficient. Moreover, the irradiation intensity of the pulsed laser light $L_1$ irradiated to target 4 is preferably $10^6$ W/cm$^2$ to $10^{12}$ W/cm$^2$. If the irradiation intensity of the pulsed laser light $L_1$ is lower than $10^6$ W/cm$^2$, generation of vacuum-ultraviolet light $L_2$ having a wavelength of 50 nm to 100 nm tends to be insufficient. On the other hand, if the irradiation intensity of the pulsed laser light $L_1$ is higher than $10^{12}$ W/cm$^2$, the amount of vacuum-ultraviolet light $L_2$ having a wavelength of 50 nm to 100 nm tends to the decrease because main wavelength region of electromagnetic wave generated when the vacuum-ultraviolet light is irradiated to the target becomes a wavelength region of 50 nm or shorter.

Various flying particles (ablator) a generated from the surface of the target 4 by irradiation of the pulsed laser light $L_1$ as described above are supplied to the surface of the polymer substrate for resin glass 6 together with vacuum-ultraviolet light $L_2$. Since the vacuum-ultraviolet light $L_2$ irradiated to the surface of the substrate 6 as described above has high absorption ratio to the material composing the polymer substrate for resin glass, the surface of the polymer substrate for resin glass 6 irradiated by vacuum-ultraviolet light $L_2$ is sufficiently activated. Since the flying particles a reach there with high energy, the flying particles a strongly adhere onto the substrate 6 and the surface of the substrate is maintained in active condition. Therefore, the surface of the substrate 6 containing carbon atoms can be maintained in active condition without nonuniformity for a long period. By laminating a hard coating layer to such an activated surface of the substrate, alkoxysilane molecules contained in the hard coating layer and the surface of the substrate are strongly bonded. As a result, a highly adhesive hard coating layer is laminated.

In the above-mentioned process of forming the inorganic layer, heating the substrate 6 at high temperature is not required for activating the surface of the substrate 6. Although the substrate temperature is not particularly limited, the temperature may generally be room temperature to about 50°C. In addition, the required time to activate the surface of the substrate 6 (laser light irradiation time) is not particularly limited either, and is determined as appropriate to optimize adhesion between the hard coating layer and the substrate. Generally, the required time is preferably about 1 second to about 10 minutes, and more preferably about 5 seconds to about 1 minute.

(Hard coating layer laminating process)

The process of laminating a hard coating layer according to the present invention concerns laminating an alkoxysilane-containing hard coating layer on a polymer substrate for resin glass having the inorganic layer interposed therebetween.

As a material for forming such a hard coating layer (a hard coating material), the same material described for the above-mentioned laminated body for resin glass of the present invention can be used.

The method for laminating the hard coating layer on the polymer substrate for resin glass is not particularly limited, and known methods by which the hard coating layer can be laminated onto the polymer substrate for resin glass can be employed as appropriate. For example, employing a method for laminating the hard coating layer by applying the hard coating material is included. Although these applying methods are not particularly limited, various coating methods including a bar coating method, a dip coating method, a flow coating method, a spray coating method and a spin coating method can be employed. Methods for forming (curing) the hard coating layer include methods for curing the hard coating layer by baking and methods for curing the hard coating layer by room temperature drying or heat drying. Although the method for curing the hard coating layer by heat drying is not particularly limited, employing a method of heat curing in the range of 100 to 140°C for 30 minutes to 2 hours is preferable.

In the present invention, since a hard coating material is applied on the surface of the polymer substrate for resin glass being maintained in an activated condition by the above-mentioned inorganic layer forming process and the reactivity between hard coating material molecules and fine particles forming the inorganic layer is high, the hard coating material molecules and the surface of the substrate are bonded strongly. For this reason, a highly adhesive hard coating is formed without applying a conventional primer coating. In addition, since the surface of the substrate activated in the above-mentioned process of forming the inorganic layer is maintained in activated condition for a long time, the process of laminating the hard coating layer is not necessarily performed immediately after the above-mentioned process of forming the inorganic layer. For example, high adhesion of the hard coating layer is achieved, even when the process of laminating the hard coating layer is performed one or more months after the process of forming the inorganic layer is performed.

Examples

The present invention is more specifically described below on the basis of Examples and Comparative Examples. However, the present invention is not limited to the following examples.

(Reference Example 1 and Examples 2 and 3 and Comparative Example 1 to 6)

The laminated body for resin glass of each Example was produced by employing a laser ablation method using the equipment illustrated in FIG. 1 for the process of forming the inorganic layer. To be more specific, firstly, laser light was focused onto the target 4 to generate plasma, and ablators a are caused to adhere onto the polymer substrate for resin glass 6 with irradiation with vacuum-ultraviolet light to form the inorganic layer.

As a polymer substrate for resin glass 6, a substrate made of polycarbonate (PC) (Iupilon Sheet (trade name) grade NF2000VU, manufactured by Mitsubishi Engineering-Plastics Corp.) was used. The size of the polymer substrate for resin glass was 40 mm long, 40 mm wide and 2 mm thick.

As a target 4, the targets made of a material listed in Table 1 were used.

[Table 1]

| | Material | Properties, manufacturer |
|---|---|---|
| Reference Example 1 | Aluminum (Al) | Composition Al:99.3%,Si:0.4%,Fe:0.3% |
| Example 2 | Silicon (Si) | Manufactured by Kojundo Chemical Laboratory Co., Ltd. Composition Si:99.999% |
| Example 3 | Titanium dioxide ($TiO_2$) | Manufactured by Kojundo Chemical Laboratory Co., Ltd. Composition $TiO_2$:99.9% |
| Comparative Example 1 | Zinc oxide (ZnO) | Manufactured by Kojundo Chemical Laboratory Co., Ltd. Composition ZnO:99.99% |
| Comparative Example 2 | Tin (Sn) | Manufactured by Kojundo Chemical Laboratory Co., Ltd. Composition Sn :99.99% |
| Comparative Example 3 | Copper (Cu) | Pure Copper |
| Comparative Example 4 | Iron (Fe) | Pure iron |
| Comparative Example 5 | Carbon (C) | Manufactured by Kojundo Chemical Laboratory Co., Ltd. Ash less than 20 ppm |
| Comparative Example 6 | Carbon (C) | Manufactured by Kojundo Chemical Laboratory Co., Ltd. Ash less than 20 ppm |

As a laser source 2, the pulsed laser (Nd-YAG) equipment, manufactured by Spectra-Physics Inc., was used. The wavelength of laser light was set to 532 nm (pulse width 7 ns, energy 1 J).

The target 4 and the polymer substrate for resin glass 6 were placed so that the angle θ1 between the laser light $L_1$ and the surface of the target 4 shown in FIG. 2 was 25 degrees; the angle θ2 between the normal line of polymer substrate for resin glass 6 and the laser light $L_1$ was 60 degrees; and the distance X between the target 4 and the polymer substrate for resin glass 6 was 80 mm. In addition, the target 4 and the polymer substrate for resin glass 6 were rotated at 6 rpm and 48 rpm respectively by motors in order to perform uniform treatment. Moreover, the degree of vacuum in the treatment container was maintained at $10^{-3}$ Torr or lower during experiments.

The shape of the focused laser light was adjusted to have an average diameter of 3.2 mm, and the irradiation intensity condition of the laser light was 1.7 GW/cm$^2$. Note that, irradiation intensity can be determined by light focusing size of the laser light (a spot area of the laser light on the target), and the relation between irradiation intensity and light focusing size is represented by the following formula (1):

$$\text{(Irradiation intensity)} = \text{(Laser light energy)} / \{\text{(Pulse width)} \times \text{(Light focusing size)}\} \quad (1)$$

The treatment time by this laser light was set to 30 seconds.

Then, as the process of laminating the hard coating layer, a hard coating layer was laminated to the polymer substrate for resin glass having the inorganic layer interposed therebetween in such a way that an alkoxysilane-containing hard coating material (KP-851, manufactured by Shin-Etsu Chemical Co., Ltd.) was applied by dipping, and then dried. A laminated body for resin glass was obtained as described above. As for the applying condition and the drying condition of this hard coating material, dip coating was performed once (for about 1 min) to the substrate on which the inorganic layer was formed, then the coated substrate was left for 20 min for setting. Thereafter baking was performed at a temperature of 130°C for 60 min. Note that, the thickness of the hard coating layer in the obtained laminated body for resin glass was 4 $\mu$m.

(Example 4)

A laminated body for resin glass was produced in a similar way to Example 2 except that a substrate of polymethyl methacrylate produced by the method to be described below was used as the polymer substrate for resin glass and baking was performed at a temperature of 100°C for 120 min.

[Substrate made of polymethyl methacrylate]

Polymethyl methacrylate (PMMA: Delpet (trade name) grade 80N, manufactured by Asahi Kasei Corporation) was used as a material. The Delpet was molded by an injection molding machine (NEX1000-9E TWF-200HHDN (trade name) manufactured by Nissei Plastic Industrial Co., Ltd.) under a clamping pressure of 80 tons to obtain a molded substrate of 2 mm thickness. The obtained molded substrate was cut to form a substrate having a size of 40 mm long, 40 mm wide and 2 mm thick. Thus, the substrate made of polymethyl methacrylate was obtained.

(Example 5)

A laminated body for resin glass was produced in a similar way to Example 3 except that a substrate made of polymethyl methacrylate similar to that used in Example 4 was used as the polymer substrate for resin glass and baking was performed at a temperature of 100°C for 120 min.

(Comparative example 7)

A laminated body for resin glass was produced in a similar way to Comparative Example 5 except that a substrate made of polymethyl methacrylate similar to that used in Example 4 was used as the polymer substrate for resin glass and baking was performed at a temperature of 100°C for 120 min.

(Comparative Example 8)

A laminated body for resin glass was produced in a similar way to Comparative Example 6 except that a substrate made of polymethyl methacrylate similar to that used in Example 4 was used as the polymer substrate for resin glass and baking was performed at a temperature of 100°C for 120 min.

<Evaluation of properties of the laminated bodies for resin glass obtained in Reference Example 1 and Examples 2 to 5 and Comparative Examples 1 to 8>

<Initial adhesion>

Tape peeling test was conducted on the laminated bodies for resin glass obtained in Examples 1 to 5 and Comparative Examples 1 to 8 to evaluate initial adhesion. To be more specific, in the tape peeling test, after a hard coating layer of each laminated body for resin glass was crosscut with a cutter knife, Sellotape (registered trademark) CT-24 manufactured by Nichiban Co., Ltd. was stuck to the crosscut part and the tape was peeled. The initial adhesion was evaluated by existence or nonexistence of peeled hard coating. Note that, the criteria for the tape peeling test are as follows:

[Evaluation criteria of initial adhesion]

A: A hard coat was not peeled off (acceptable).

C: A hard coat was peeled off (not acceptable).

The obtained results were listed in Table 2. Note that, the following evaluations were not conducted on Comparative Example 5 to 8, which had poor initial adhesion.

<Heat resistance>

Heat resistance of the laminated bodies for resin glass obtained in Reference Example 1 and Examples 2 to 5 and Comparative Examples 1 to 4 was evaluated. To be more specific, after heat resistance test was conducted in which each laminated body for resin glass was maintained under a temperature of 110°C for 720 hours, tape peeling test employing a similar method to the method employed in the initial adhesion evaluation was conducted to evaluate heat resistance. Note that, the evaluation criteria are the same as the evaluation criteria for the initial adhesion evaluation. The obtained results are listed in Table 2.

<Moisture resistance >

Moisture resistance of the laminated bodies for resin glass obtained in Reference Examples Examples 2 to 5 and Comparative Examples 1 to 4 was evaluated. To be more specific, after moisture resistance test was conducted in which each laminated body for resin glass was maintained under a temperature of 50°C and a relative humidity of 95% for 720 hours, tape peeling test employing a similar method to the method employed in the initial adhesion evaluation was conducted to evaluate moisture resistance. The obtained results are listed in Table 2.

<Water resistance>

Water resistance of the laminated bodies for resin glass obtained in Reference Examples Examples 2 to 5 and Comparative Examples 1 to 4 was evaluated. To be more specific, after water resistance test was conducted in which each laminated body for resin glass was immersed in water at a temperature of 40°C for 720 hours, tape peeling test employing a similar method to the method employed in the initial adhesion evaluation was conducted to evaluate water resistance. The obtained results are listed in Table 2.

<Thermal shock resistance>

Thermal shock resistance of the laminated bodies for resin glass obtained in Examples 1 to 5 and Comparative Examples 1 to 4 was evaluated. To be more specific, after thermal shock resistance test was conducted in which each laminated body for resin glass was alternately exposed to a temperature of -30 °C for 90 min and 110°C for 90 min and 100 cycles of this exposure was repeated, tape peeling test employing a similar method to the method employed in the initial adhesion evaluation was conducted to evaluate thermal shock resistance. The obtained results are listed in Table 2.

<Weatherability>

Weatherability of the laminated bodies for resin glass obtained in Examples 1 to 5 and Comparative Examples 1 to 4 was evaluated. To be more specific, accelerated weatherability test described below was conducted to evaluate weatherability. For this accelerated weatherability test, the accelerated weatherability test equipment (KU-R5C1-A (trade name), manufactured by Daipla Wintes Co., Ltd.) using a metal halide lamp as a light source was used as a test equipment. After three conditions, that is, light irradiation condition, darkness condition and dew formation condition, were sequentially applied, the number of cycles was counted until the hard coating peeled off by itself. The above-mentioned irradiation condition was that a light was irradiated for 4 hours under light intensity of 90 mW/cm$^2$, a black panel temperature of 63°C and a relative humidity of 70%. The above-mentioned darkness condition was that no light irradiation was made for 4 hours under a condition of a black panel temperature of 70°C and a relative humidity of 90%. The above-mentioned dew formation condition was that the temperature of black panel naturally decreased from 70°C to 30°C under relative humidity of 98% without light irradiation, and this state was maintained for 4 hours. The obtained results are listed in Table 2.

<Abrasion-resistance >

In order to evaluate abrasion-resistance, Tabor abrasion test was conducted on the laminated bodies for resin glass obtained in Reference Example 1 and Examples 2 to 5 and Comparative Examples 1 to 4. To be more specific, Tabor abrasion test was conducted on each laminated body for resin glass using a Tabor abrasion tester equipped with CS-10F abrasion wheels with a load of 500 g for each wheel for 500 cycles. The difference (ΔH) between a haze before Tabor abrasion test and a haze after Tabor abrasion test was measured to evaluate abrasion-resistance. The obtained results are listed in Table 2.

[Table 2]

| | Material of substrate | Target | Irradiation intensity (GW/cm$^2$) | Initial adhesion | Heat resistance | Thermal shock resistance | Moisture resistance | Water resistance | Weatherability | Abrasion resistance ΔH (%) |
|---|---|---|---|---|---|---|---|---|---|---|
| * Example 1 | PC | A1 | 1.5 | A | A | A | A | A | 18 | 9.1 |
| Example 2 | | Si | 1.5 | A | A | A | A | A | 106 | 7.2 |
| Example 3 | | TiO$_2$ | 1.5 | A | A | A | A | A | 128 | 10.5 |
| Comparative Example 1 | | ZnO | 1.5 | A | C | A | C | C | 4 | 11.3 |
| Comparative Example 2 | | Sn | 1.5 | A | C | C | C | C | 4 | 13.1 |
| Comparative Example 3 | | cu | 1.5 | A | A | A | A | C | 8 | 9.4 |
| Comparative Example 4 | | Fe | 1.5 | A | A | A | C | C | 8 | 8.7 |
| Comparative Example 5 | | C | 1.5 | C | - | - | - | - | - | - |
| Comparative Example 6 | | C | 4.6 | C | - | - | - | - | - | - |
| Example 4 | PMMA | Si | 1.5 | A | A | A | A | A | 100 | 5.7 |
| Example 5 | | TiO$_2$ | 1.5 | A | A | A | A | A | 112 | 7.5 |
| Comparative Example 7 | | C | 1.5 | C | - | - | - | - | - | - |
| Comparative Example 8 | | C | 4.6 | C | - | - | - | - | - | - |

*Reference

(Reference Examples 6 to 9)

By employing a sputtering method for the process of forming the inorganic layer and by employing a process of laminating the hard coating layer similar to the process of laminating the hard coating layer employed in Reference Example 1, laminated bodies for resin glass were produced.

To be more specific, the inorganic layer was formed onto the polymer substrate for resin glass by sputtering treatment using sputtering equipment (manufactured by Ulvac, Inc.). Thereafter, a laminated body for resin glass was obtained by laminating a hard coating layer. Then, the process of laminating the hard coating layer was performed to produce the laminated body for resin glass. In such a sputtering treatment, the base material made of the same material used in Example 2 was used in each Reference Example 6 and 7 as the target, and the base material made of the same material used in Example 3 was used in each Reference Example 8 and 9 as the target. In addition, the substrate made of the same polycarbonate (PC) used in Example 1 was used as the polymer substrate for resin glass.

In the sputtering treatment, first, the substrate cut into 40 mm long and 40 mm wide was fixed to a sample holder in the sputtering equipment, and the inside of the equipment was vacuumed by a vacuum pump and an oil diffusion pump down to $2 \times 10^{-6}$ Torr. After the pressure of the inside of the equipment reached $2 \times 10^{-6}$ Torr, Ar gas (in the case where the target is Si (in the case of Reference Examples 6 and 7)), or mixed gas of Ar and $O_2$ (in the case where the target is $TiO_2$ (in the case of Reference Examples 8 and 9)) was introduced to the inside of equipment up to a pressure of $3 \times 10^{-6}$ Torr. Then, electric power of 50 W (in the case of Examples 6 and 7) or 150 W (in the case of Reference Examples 8 and 9) was supplied to the power source of the target to generate plasma. After plasma was generated as described above, the plasma was irradiated to the substrate for a certain time period (Reference Example 6: 90 sec, Reference Example 7: 50 sec, Reference example 8: 330 sec and Reference Example 9: 155 sec). After that, power source of the target was turned off, and after the target was cooled, the pressure was increased to the atmospheric pressure using nitrogen. Then the substrate was taken out from the equipment. Each thickness of the obtained inorganic layers is listed in Table 3.

(Reference Example 10)

A laminated body for resin glass was produced in a similar way to Reference Example 6 except that a substrate made of polymethyl methacrylate similar to that used in Example 4 was used as the polymer substrate for resin glass and baking was performed at a temperature of 100°C for 120 min. The thickness of the obtained inorganic layer is listed in Table 3.

(Reference Example 11)

A laminated body for resin glass was produced in a similar way to Reference Example 7 except that a substrate made of polymethyl methacrylate similar to that used in Example 4 was used as the polymer substrate for resin glass and baking was performed at a temperature of 100°C for 120 min. The thickness of the obtained inorganic layer is listed in Table 3.

(Reference Example 12)

A laminated body for resin glass was produced in a similar way to Reference Example 8 except that a substrate made of polymethyl methacrylate similar to that used in Example 4 was used as the polymer substrate for resin glass and baking was performed at a temperature of 100°C for 120 min. The thickness of the obtained inorganic layer is listed in Table 3.

(Reference Example 13)

A laminated body for resin glass was produced in a similar way to Reference Example 9 except that a substrate made of polymethyl methacrylate similar to that used in Example 4 was used as the polymer substrate for resin glass and baking was performed at a temperature of 100°C for 120 min. The thickness of the obtained inorganic layer is listed in Table 3.

<Evaluation of properties of the laminated bodies for resin glass obtained in Reference Examples 6 to 13>

Initial adhesion, heat resistance, weatherability and abrasion resistance of the laminated bodies for resin glass obtained in Reference Examples 6 to 13 was evaluated. For evaluation methods of such initial adhesion, heat resistance, weatherability and abrasion resistance, employed methods were the evaluation methods of initial adhesion, heat resistance, weatherability and abrasion resistance employed in the above-mentioned Reference Example 1 and Examples 2 to 5 and Comparative Examples 1 to 8. The obtained results are listed in Table 3.

[Table 3]

| | Material of substrate | Material of target | Treatment time (s) | Film thickness (nm) | Initial adhesion | Water resistance | Weatherability | Abrasion resistance ΔH (%) |
|---|---|---|---|---|---|---|---|---|
| Reference Example 6 | PC | Si | 90 | 8.8 | A | A | 50 | 7.4 |
| Reference Example 7 | | | 50 | 4.4 | A | A | 22 | 7.1 |
| Reference Example 8 | | $TiO_2$ | 330 | 8.8 | A | A | 64 | 9.8 |
| Reference Example 9 | | | 155 | 4.4 | A | A | 28 | 8.7 |
| Reference Example 10 | PMMA | Si | 90 | 8.8 | A | A | 40 | 6.3 |
| Reference Example 11 | | | 50 | 4.4 | A | A | 36 | 5.9 |
| Reference Example 12 | | $TiO_2$ | 330 | 8.8 | A | A | 50 | 7.1 |
| Reference Example 13 | | | 155 | 4.4 | A | A | 30 | 6.8 |

As is apparent from the results listed in Tables 2 and 3, it is observed that all the properties of each of the laminated bodies for resin glass according to the present invention whose inorganic layers are made of aluminum, silicon or titania (Reference Examples 1 and 6 to 13 and Examples 2 to 5) were excellent. In contrast, water resistance and weatherability of all resin glass of the laminated bodies for resin glass whose inorganic layers are made of a material other than aluminum, silicon and titania (Comparative Example 1 to 7), were inferior to those of the laminated bodies for resin glass of the present invention (Reference Example 1 and Examples 2 to 5).

**Industrial Applicability**

As described above, according to the present invention, it is possible to provide a laminated body for resin glass, and a method for manufacturing the laminated body for resin glass capable of efficiently and reliably manufacturing the laminated body for resin glass. The laminated body for resin glass has sufficiently high adhesion between a polymer substrate for resin glass and a hard coating layer without a conventional primer coating being performed, and can exhibit excellent abrasion-resistance as well as high weatherability by which the polymer substrate for resin glass is sufficiently prevented from degradation caused by ultraviolet irradiation.

Accordingly, since the laminated body for resin glass of the present invention has excellent adhesion and weatherability, the laminated body for resin glass is particularly useful as a material for a resin glass used for a window component for an automobile.

**Claims**

1. A laminated body for resin glass comprising:

   a polymer substrate having a thickness of 1 to 10 mm for resin glass;
   an inorganic layer formed without primer coating being performed by causing fine particleshaving an average particle diameter of from 0.1 to 500 nm of at least one substance selected from the group consisting of silicon, titanium, a silicon compound and a titanium compound to adhere onto the polymer substrate for resin glass; and
   an alkoxysilane-containing hard coating layer laminated to the polymer substrate for resin glass having the inorganic layer interposed therebetween,
   said inorganic layer being formed: by irradiating laser light to a surface of a base material to generate vacuum-ultraviolet light having a wavelength of 50 nm to 100 nm and flying particles; and by causing the flying particles to adhere onto the polymer substrate for resin glass with irradiation of the vacuum-ultraviolet light, said base material comprising at least one substance selected from the group consisting of silicon, titanium, a silicon compound and a titanium compound, wherein the term vacuum-ultraviolet light having a wavelength region from 50 to 100 nm is to be understood as vacuum-ultraviolet light having at least a part of wavelength region from 50 to 100 nm in accordance with the description,
   wherein for said alkoxysilane-containing hard coating layer, a compound containing an organopolysiloxane composition including a condensation compound of a hydrolyzed organosilane represented by the general formula (1) as an alkoxysilane:

   $$(R^1)_n Si(OR^2)_{4-n} \qquad (1)$$

   is used, wherein each $R^1$ may be the same or different and represents a monovalent organic group containing 1 to 10 carbon atoms; n represents an integer of 0 to 2; and each $R^2$ may be the same or different and represents a hydrogen atom or a monovalent organic group; and
   wherein the thickness of the hard coating layer after heat curing is 0.2 to 20 $\mu$m.

2. The laminated body for resin glass according to claim 1,
   wherein the polymer substrate for resin glass comprises at least one resin selected from the group consisting of a polycarbonate resin, a polymethyl methacrylate resin, a methyl methacrylate resin, a transparent acrylonitrile butadiene styrene resin, a transparent polystyrene resin, a transparent epoxy resin, a polyarylate, a polysulfone, a polyethersulfone, a transparent nylon resin, a transparent polybutylene terephthalate, a transparent fluororesin, poly-4-methylpentene-1, a transparent phenoxy resin, a polyimide resin and a transparent phenol resin.

3. The laminated body for resin glass according to claim 1,
   wherein the polymer substrate for resin glass comprises a polycarbonate resin.

4. A method for manufacturing a laminated body according to claim 1, the method comprising the steps of:

forming an inorganic layer by causing fine particles having an average particle diameter of from 0.1 to 500 nm of at least one substance selected from the group consisting of silicon, titanium, a silicon compound and a titanium compound to adhere onto a polymer substrate for resin glass; and

laminating an alkoxysilane-containing hard coating layer to the polymer substrate for resin glass having the inorganic layer interposed therebetween,

said step of forming the inorganic layer is performed by irradiating laser light to a surface of a base material to generate vacuum-ultraviolet light having a wavelength of 50 nm to 100 nm and flying particles; and by causing the flying particles to adhere onto the polymer substrate for resin glass with irradiation of the vacuum-ultraviolet light, said base material comprising at least one substance selected from the group consisting of silicon, titanium, a silicon compound and a titanium compound, wherein the term vacuum-ultraviolet light having a wavelength region from 50 to 100 nm is to be understood as vacuum-ultraviolet light having at least a part of wavelength region from 50 to 100 nm in accordance with the description,

wherein for said alkoxysilane-containing hard coating layer, a compound containing an organopolysiloxane composition including a condensation compound of a hydrolyzed organosilane represented by the general formula (1) as an alkoxysilane:

$$(R^1)_nSi(OR^2)_{4-n} \qquad (1)$$

is used, wherein each $R^1$ may be the same or different and represents a monovalent organic group containing 1 to 10 carbon atoms; n represents an integer of 0 to 2; and each $R^2$ may be the same or different and represents a hydrogen atom or a monovalent organic group; and

wherein the thickness of the hard coating layer after heat curing is 0.2 to 20 $\mu$m.

5. The method for manufacturing a laminated body for resin glass according to claim 4,
wherein the laser light is a pulsed laser light having a pulse width of 100 picoseconds to 100 nanoseconds and an irradiation intensity of $10^6$ W/cm$^2$ to $10^{12}$ W/cm$^2$.

6. The method for manufacturing a laminated body for resin glass according to claim 4,
wherein the flying particles are caused to adhere onto the surface of the polymer substrate for resin glass under a reduced pressure condition and/or a shielding gas atmosphere comprising at least one gas selected from the group consisting of hydrogen gas, helium gas, neon gas and argon gas.

7. The method for manufacturing a laminated body for resin glass according to claim 4,
wherein the polymer substrate for resin glass comprises at least a resin selected from the group consisting of a polycarbonate resin, a polymethyl methacrylate resin, a methyl methacrylate resin, a transparent acrylonitrile butadiene styrene resin, a transparent polystyrene resin, a transparent epoxy resin, a polyarylate, a polysulfone, a polyethersulfone, a transparent nylon resin, a transparent polybutylene terephthalate, a transparent fluororesin, poly-4-methylpentene-1, a transparent phenoxy resin, a polyimide resin and a transparent phenol resin.

8. The method for manufacturing a laminated body for resin glass according to claim 4,
wherein the polymer substrate for resin glass comprises a polycarbonate resin.

**Patentansprüche**

1. Laminierter Körper für Harzglas, umfassend:

ein Polymersubstrat mit einer Dicke von 1 bis 10 mm für Harzglas;

eine anorganische Schicht, die ohne eine Grundierungsmittelbeschichtung gebildet ist, die dadurch ausgeführt ist, dass bewirkt wird, dass Feinteilchen mit einem mittleren Teilchendurchmesser von 0,1 bis 500 nm von zumindest einer Substanz ausgewählt aus der Gruppe bestehend aus Silizium, Titan, einer Siliziumverbindung und einer Titanverbindung, auf dem Polymersubstrat für Harzglas anhaften; und

eine Alkoxysilan-enthaltende Hartbeschichtungsschicht, die zu dem Polymersubstrat für Harzglas mit der dazwischen eingefügten anorganischen Schicht laminiert ist,

wobei die anorganische Schicht gebildet ist: durch Bestrahlen von Laserlicht auf eine Oberfläche eines Grundmaterials, um Vakuum-Ultraviolettlicht mit einer Wellenlänge von 50 nm bis 100 nm und fliegende Teilchen zu erzeugen; und durch Bewirken, dass die fliegenden Teilchen auf das Polymersubstrat für Harzglas mit der Bestrahlung des Vakuum-Ultraviolettlichts anhaften, wobei das Grundmaterial zumindest eine Substanz ausgewählt aus der Gruppe bestehend aus Silizium, Titan, einer Siliziumverbindung und einer Titanverbindung umfasst, wobei der Begriff Vakuum-Ultraviolettlicht mit einem Wellenlängenbereich von 50 bis 100 nm als Vakuum-Ultraviolettlicht mit zumindest einem Teil vom Wellenlängenbereich von 50 bis 100 nm in Übereinstimmung mit der Beschreibung zu verstehen ist,
wobei für die Alkoxysilan-enthaltende Hartbeschichtungsschicht eine Verbindung verwendet wird, die eine Organopolysiloxanzusammensetzung enthält, beinhaltend eine Kondensationsverbindung eines hydrolysierten Organosilans dargestellt durch die allgemeine Formel 1 als ein Alkoxysilan:

$$(R^1)_n Si(OR^2)_{4-n} \qquad (1),$$

wobei jedes $R^1$ gleich oder unterschiedlich sein kann und eine monovalente organische Gruppe darstellt, die 1 bis 10 Kohlenstoffatome enthält; n eine ganze Zahl von 0 bis 2 darstelllt; und jedes $R^2$ gleich oder unterschiedlich sein kann und ein Wasserstoffatom oder eine einwertige organische Gruppe darstellt; und wobei die Dicke der Hartbeschichtungsschicht nach dem Wärmehärten 0,2 bis 20 $\mu$m ist.

2. Laminierter Körper für Harzglas nach Anspruch 1,
wobei das Polymersubstrat für Harzglas zumindest ein Harz ausgewählt aus der Gruppe bestehend aus einem Polycarbonatharz, einem Polymethylmethacrylatharz, einem Methylmethacrylatharz, einem transparenten Acrylonitrilbutadienstyrolharz, einem transparenten Polystyrolharz, einem transparenten Epoxyharz, einem Polyarylat, einem Polysulfon, einem Polyethersulfon, einem transparenten Nylonharz, einem transparenten Polybutylenterephthalat, einem transparenten Fluorharz, Poly-4-Methylpenten-1, einem transparenten Phenoxyharz, einem Polyimidharz und einem transparenten Phenolharz umfasst.

3. Laminierter Körper für Harzglas nach Anspruch 1,
wobei das Polymersubstrat für Harzglas ein Polycarbonatharz umfasst.

4. Verfahren zur Herstellung eines laminierten Körpers nach Anspruch 1, wobei das Verfahren die Schritte umfasst von:

Bilden einer anorganischen Schicht durch Bewirken, dass Feinteilchen mit einem mittleren Teilchendurchmesser von 0,1 bis 500 nm von zumindest einer Substanz ausgewählt aus der Gruppe bestehend aus Silizium, Titan, einer Siliziumverbindung und einer Titanverbindung auf einem Polymersubstrat für Harzglas anhaften; und Laminieren einer Alkoxysilan-enthaltenden Hartbeschichtungsschicht zu dem Polymersubstrat für Harzglas mit der dazwischen eingefügten anorganischen Schicht,
wobei der Schritt des Bildens der anorganischen Schicht ausgeführt wird durch Bestrahlen von Laserlicht auf eine Oberfläche eines Grundmaterials, um Vakuum-Ultraviolettlicht mit einer Wellenlänge von 50 nm bis 100 nm und fliegende Teilchen zu erzeugen; und durch Bewirken, dass die fliegenden Teilchen auf das Polymersubstrat für Harzglas mit der Bestrahlung des Vakuum-Ultraviolettlichts anhaften, wobei das Grundmaterial zumindest eine Substanz ausgewählt aus der Gruppe bestehend aus Silizium, Titan, einer Siliziumverbindung und einer Titanverbindung umfasst, wobei der Begriff Vakuum-Ultraviolettlicht mit einem Wellenlängenbereich von 50 bis 100 nm als Vakuum-Ultraviolettlicht mit zumindest einem Teil vom Wellenlängenbereich von 50 bis 100 nm in Übereinstimmung mit der Beschreibung zu verstehen ist,
wobei für die Alkoxysilan-enthaltende Hartbeschichtungsschicht eine Verbindung verwendet wird, die eine Organopolysiloxanzusammensetzung enthält, beinhaltend eine Kondensationsverbindung eines hydrolysierten Organosilans dargestellt durch die allgemeine Formel 1 als ein Alkoxysilan:

$$(R^1)_n Si(OR^2)_{4-n} \qquad (1),$$

wobei jedes $R^1$ gleich oder unterschiedlich sein kann und eine monovalente organische Gruppe darstelllt, die 1 bis 10 Kohlenstoffatome enthält; n eine ganze Zahl von 0 bis 2 darstelllt; und jedes $R^2$ gleich oder unterschiedlich sein kann und ein Wasserstoffatom oder eine einwertige organische Gruppe darstellt; und wobei die Dicke der Hartbeschichtungsschicht nach dem Wärmehärten 0,2 bis 20 $\mu$m ist.

5. Verfahren zur Herstellung eines laminierten Körpers für Harzglas nach Anspruch 4,
wobei das Laserlicht ein gepulstes Laserlicht mit einer Pulsbreite von 100 Picosekunden bis 100 Nanosekunden und einer Bestrahlungsintensität von $10^6$ W/cm$^2$ bis $10^{12}$ W/cm$^2$ ist.

**6.** Verfahren zur Herstellung eines laminierten Körpers für Harzglas nach Anspruch 4, wobei bewirkt wird, dass die fliegenden Teilchen auf der Oberfläche des Polymersubstrats für Harzglas unter einer Bedingung eines reduzierten Drucks und/oder einer Schutzgasatmosphäre, umfassend zumindest ein Gas ausgewählt aus der Gruppe bestehend aus Wasserstoffgas, Heliumgas, Neongas und Argongas, anhaften.

**7.** Verfahren zur Herstellung eines laminierten Körpers für Harzglas nach Anspruch 4, wobei das Polymersubstrat für Harzglas zumindest ein Harz ausgewählt aus der Gruppe bestehend aus einem Polycarbonatharz, einem Polymethylmethacrylatharz, einem Methylmethacrylatharz, einem transparenten Acrylonitrilbutadienstyrolharz, einem transparenten Polystyrolharz, einem transparenten Epoxyharz, einem Polyarylat, einem Polysulfon, einem Polyethersulfon, einem transparenten Nylonharz, einem transparenten Polybutylenterephthalat, einem transparenten Fluorharz, Poly-4-Methylpenten-1, einem transparenten Phenoxyharz, einem Polyimidharz und einem transparenten Phenolharz umfasst.

**8.** Verfahren zur Herstellung eines laminierten Körpers für Harzglas nach Anspruch 4, wobei das Polymersubstrat für Harzglas ein Polycarbonatharz umfasst.


**Revendications**

**1.** Corps stratifié pour verre de résine comprenant :

un substrat polymère ayant une épaisseur allant de 1 à 10 mm pour verre de résine ;
une couche inorganique formée sans revêtement primaire qui est réalisée en amenant des fines particules ayant un diamètre de particule moyen allant de 0,1 à 500 nm d'au moins une substance choisie dans le groupe constitué de silicium, de titane, d'un composé de silicium et d'un composé de titane à adhérer sur le substrat polymère pour verre de résine ; et
une couche de revêtement dur contenant de l'alcoxysilane stratifiée sur le substrat polymère pour verre de résine ayant la couche inorganique interposée entre ceux-ci,
ladite couche inorganique étant formée : en irradiant de la lumière laser sur une surface d'un matériau de base pour générer de la lumière ultraviolette sous vide ayant une longueur d'onde allant de 50 nm à 100 nm et des particules volantes ; et en amenant les particules volantes à adhérer sur le substrat polymère pour verre de résine par irradiation de la lumière ultraviolette sous vide, ledit matériau de base comprenant au moins une substance choisie dans le groupe constitué de silicium, de titane, d'un composé de silicium et d'un composé de titane, où le terme lumière ultraviolette sous vide ayant une région de longueurs d'onde allant de 50 à 100 nm doit être compris comme une lumière ultraviolette sous vide ayant au moins une partie de région de longueurs d'onde allant de 50 à 100 nm conformément à la description,
où, pour ladite couche de revêtement dur contenant de l'alcoxysilane, un composé contenant une composition d'organopolysiloxane comportant un composé de condensation d'un organosilane hydrolysé représenté par la formule générale (1) comme un alcoxysilane .

$$(R^1)_n Si(OR^2)_{4-n} \qquad (1)$$

est utilisé, où chaque $R^1$ peut être identique ou différent et représente un groupe organique monovalent contenant 1 à 10 atomes de carbone ; n représente un entier allant de 0 à 2 ; et chaque $R^2$ peut être identique ou différent et représente un atome d'hydrogène ou un groupe organique monovalent ; et
où l'épaisseur de la couche de revêtement dur après thermodurcissement est de 0,2 à 20 $\mu$m.

**2.** Corps stratifié pour verre de résine selon la revendication 1, dans lequel le substrat polymère pour verre de résine comprend au moins une résine choisie dans le groupe constitué d'une résine de polycarbonate, d'une résine de méthacrylate de polyméthyle, d'une résine de méthacrylate de méthyle, d'une résine acrylonitrile-butadiène-styrène transparente, d'une résine de polystyrène transparente, d'une résine époxy transparente, d'un polyarylate, d'une polysulfone, d'une polyéthersulfone, d'une résine de nylon transparente, d'un téréphtalate de polybutylène transparent, d'une résine fluorée transparente, d'un poly-4-méthylpentène-1, d'une résine phénoxy transparente, d'une résine de polyimide et d'une résine phénolique transparente.

**3.** Corps stratifié pour verre de résine selon la revendication 1, dans lequel le substrat polymère pour verre de résine comprend une résine de polycarbonate.

**4.** Procédé de fabrication d'un corps stratifié selon la revendication 1, le procédé comprenant les étapes qui consistent :

à former une couche inorganique en amenant des fines particules ayant un diamètre de particule moyen allant de 0,1 à 500 nm d'au moins une substance choisie dans le groupe constitué de silicium, de titane, d'un composé de silicium et d'un composé de titane à adhérer sur un substrat polymère pour verre de résine ; et

à stratifier une couche de revêtement dur contenant de l'alcoxysilane sur le substrat polymère pour verre de résine ayant la couche inorganique interposée entre ceux-ci,

ladite étape de formation de la couche inorganique est effectuée en irradiant de la lumière laser sur une surface d'un matériau de base pour générer de la lumière ultraviolette sous vide ayant une longueur d'onde allant de 50 nm à 100 nm et des particules volantes ; et en amenant les particules volantes à adhérer sur le substrat polymère pour verre de résine par irradiation de la lumière ultraviolette sous vide, ledit matériau de base comprenant au moins une substance choisie dans le groupe constitué de silicium, de titane, d'un composé de silicium et d'un composé de titane, où le terme lumière ultraviolette sous vide ayant une région de longueurs d'onde allant de 50 à 100 nm doit être compris comme une lumière ultraviolette sous vide ayant au moins une partie de région de longueurs d'onde allant de 50 à 100 nm conformément à la description,

où, pour ladite couche de revêtement dur contenant de l'alcoxysilane, un composé contenant une composition d'organopolysiloxane comportant un composé de condensation d'un organosilane hydrolysé représenté par la formule générale (1) comme un alcoxysilane :

$$(R^1)_n Si(OR^2)_{4-n} \qquad (1)$$

est utilisé, où chaque $R^1$ peut être identique ou différent et représente un groupe organique monovalent contenant 1 à 10 atomes de carbone ; n représente un entier allant de 0 à 2 ; et chaque $R^2$ peut être identique ou différent et représente un atome d'hydrogène ou un groupe organique monovalent ; et

où l'épaisseur de la couche de revêtement dur après thermodurcissement est de 0,2 à 20 $\mu$m.

**5.** Procédé de fabrication d'un corps stratifié pour verre de résine selon la revendication 4,
dans lequel la lumière laser est une lumière laser pulsée ayant une largeur d'impulsion allant de 100 picosecondes à 100 nanosecondes et une intensité d'irradiation allant de $10^6$ W/cm$^2$ à $10^{12}$ W/cm$^2$.

**6.** Procédé de fabrication d'un corps stratifié pour verre de résine selon la revendication 4,
dans lequel les particules volantes sont amenées à adhérer sur la surface du substrat polymère pour verre de résine sous une condition de pression réduite et/ou une atmosphère de gaz de protection comprenant au moins un gaz choisi dans le groupe constitué d'hydrogène gazeux, d'hélium gazeux, de néon gazeux et d'argon gazeux.

**7.** Procédé de fabrication d'un corps stratifié pour verre de résine selon la revendication 4,
dans lequel le substrat polymère pour verre de résine comprend au moins une résine choisie dans le groupe constitué d'une résine de polycarbonate, d'une résine de méthacrylate de polyméthyle, d'une résine de méthacrylate de méthyle, d'une résine acrylonitrile-butadiène-styrène transparente, d'une résine de polystyrène transparente, d'une résine époxy transparente, d'un polyarylate, d'une polysulfone, d'une polyéthersulfone, d'une résine de nylon transparente, d'un téréphtalate de polybutylène transparent, d'une résine fluorée transparente, d'un poly-4-méthylpentène-1, d'une résine phénoxy transparente, d'une résine de polyimide et d'une résine phénolique transparente.

**8.** Procédé de fabrication d'un corps stratifié pour verre de résine selon la revendication 4,
dans lequel le substrat polymère pour verre de résine comprend une résine de polycarbonate.

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005126789 A
- JP 2005126788 A
- JP 2005126785 A
- JP 2005126609 A
- EP 1070762 A1
- EP 0726579 A2
- WO 0202320 A1
- WO 0147704 A1
- US 2004018364 A1
- US 6090490 A

**Non-patent literature cited in the description**

- Polycarbonate Resin Handbook. Nikkan Kogyo Shimbun Ltd, 28 August 1992